# EUROPEAN PATENT APPLICATION

(11) **EP 2 515 443 A1**
(43) Date of publication of application: **24.10.2012**
(21) Application number: 11425112.7
(22) Date of filing: 21.04.2011
(51) Int. Cl.: H03M 9/00

(54) **Data serializer**

(71) Applicant: STMicroelectronics SA, 92120 Montrouge (FR); STMicroelectronics Srl, 20864 Agrate Brianza (IT); L'Université de Monastir, 5000 Monastir (TN)
(72) Inventor: Zid, Mounir, 5000 Monastir (TN); Scandurra, Alberto, 20041 Agrate Brianza (IT); Pistritto, Carmelo, 20041 Agrate Brianza (IT); Tourki, Rached, 5000 Monastir (TN)
(74) Representative: Style, Kelda Camilla Karen

(57) **Abstract**

A data serializer comprising an input configured to receive a plurality of sets of parallel data, each set of data comprising n bits and at least one serializing stage configured to receive a set of n bits of parallel data and to convert said parallel data to a serial stream of data, said at least one serializing stage comprising a chain of flip flops each of which is arranged to selectively receive one of a bit of data and data output from a preceding flip flop, an output of a last flip flop of said chain of flip flops providing said serial stream of data.

## Description

The present invention relates to a data serializer.

Increasingly, system-on-chips SoC demand more bandwidth. There may be wide data paths for shared buses and network on chips. However there may be physical constraints which need to be addressed such as delay, EM, crosstalk and the like. There may also be physical constraints such as wire congestion and placement and routing complexity. For example, an optical SoC may require parallel to serial and serial to parallel convertors.

According to an embodiment, there is provided a data serializer comprising: an input configured to receive a plurality of sets of parallel data, each set of data comprising n bits; and at least one serializing stage configured to receive a set of n bits of parallel data and to convert said parallel data to a serial stream of data, said at least one serializing stage comprising a chain of flip flops each of which is arranged to selectively receive one of a bit of data and data output from a preceding flip flop, an output of a last flip flop of said chain of flip flops providing said serial stream of data.

The data serializer may comprise an input flip flop, said input flip flop being arranged to selectively receive a first bit of said set of data and a low logic level, an output of said input flip flop being provided to an input of a first flip flop of said chain.

The data serializer may comprise a plurality of serializing stages each configured to serialize a different set of data.

Each serializing stage may be clocked by a clock signal having the same clock frequency but a different phase such that data is clocked out of each of said serializing stages at different times.

The data serializer may comprise a multiplexing arrangement configured to combine the output of each of the serializing stages into a single serial stream of data.

The multiplexing arrangement may comprise a plurality of multiplexing layers.

The data serializer may comprise a controller configured to provide a control signal for the serializing stage or respective control signals for each of said serializing stages to control the loading of a set of data into a respective serializing stage.

The controller may be configured to provide the or each signal responsive to a data request signal being asserted.

The controller may be configured to provide a reset signal for resetting at least one serializing stage.

The input may comprise an interface having a plurality of data stores, each data store being sized so as to be able to store a set of data.

The interface may be configured to cause a set of data to be shifted through said data stores.

At least one of said data stores may be configured to output said data to the or one serializing stage only when said serializing stage is ready to serialize said data.

At least one of said data stores may comprise a controller configured to stall said data store if said state of said data store is to be unchanged.

The controller may be configured to stall said data store by gating a clock signal applied to said data store.

According to another embodiment an integrated circuit comprises a data serializer as discussed above.

According to another embodiment, a network on chip port comprises: a data serializer configured to convert parallel data into serialized data and to transmit said serialize data; and a data deserializer configured to receive serial data and convert said serial data into parallel data.

Reference is now made by way of example only to the accompanying drawings in which:
Figure 1 shows schematically an integrated circuit;
Figure 2 shows a deserializer of figure 1 in more detail;
Figure 3 shows a serializer of figure 1 in more detail;
Figure 4 shows an optical network on-chip node;
Figure 5 schematically shows the physical architecture of an integrated circuit having an optical network on chip NoC;
Figure 6 shows one stage of the serializer of figure 3;
Figure 7 shows the structure of one of the blocks of figure 6, in more detail;
Figure 8 shows a timing diagram for the one stage of the serializer;
Figure 9 schematically shows a four-stage serializer;
Figures 10a and 10b show the timing diagram for the four-stage serializer of figure 9;
Figure 11 shows a controller for the serializer of figure 9 in more detail;
Figure 12 shows a timing diagram associated with the controller of figure 11;
Figure 13 shows schematically the interface of the serializer of figure 3;
Figure 14 shows the control circuitry of figure 13 in more detail; and
Figure 15 shows a controller.

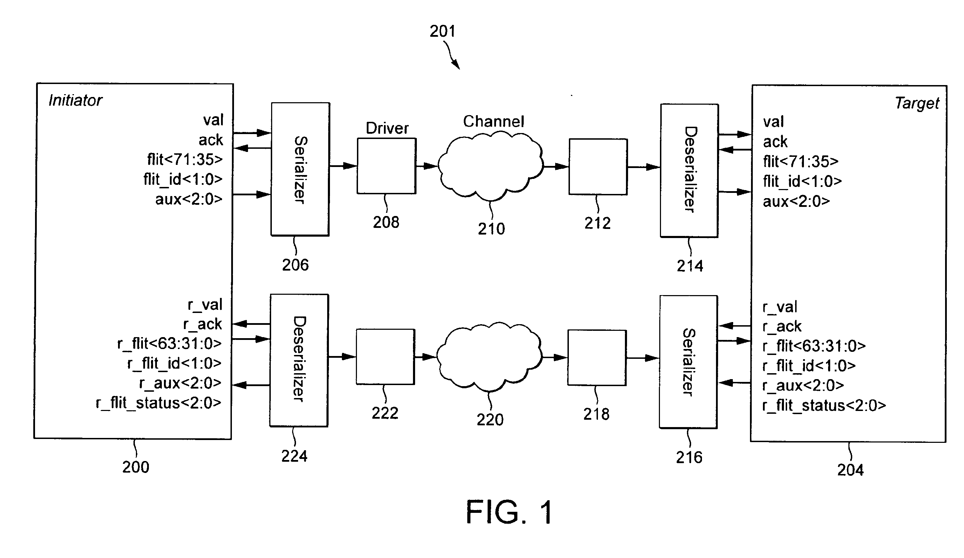

Reference is made to Figure 1 which schematically shows an integrated circuit 201 in which embodiments may be incorporated. The integrated circuit 201 has an initiator 200 which is arranged to communicate with a target 204. The initiator 200 will typically issue requests which are sent to the target 204 and the target 204 will typically respond to the requests. The responses are typically sent back to the initiator 200.

It should be appreciated that in practice, more than one initiator 200 may be provided and/or more than one target 204 may be provided. It should also be appreciated that a given initiator may be a target. Additionally or alternatively, a given target may also be an initiator.

The requests output by the initiator 200 are output in a parallel format to a first serializer 206 which converts the parallel format request into a serial form. The serialized data is output to a first driver 208 which put the data onto a first channel 210. The output end of the first channel is input to trans impedance amplifier 212. The output of the amplifier is input to a first deserializer 214. The deserializer 214 processes the received serial stream back into the parallel format. The requests, in the parallel format, are output to the target 204.

A similar path is provided for the responses to the request. The responses output by the target 204 are output in a parallel format to a second serializer 216 which converts the parallel format response into a serial form. The serialized data is output to a driver 218 which put the data onto a second channel 220. The output end of the second channel is input to a driver 222. The output of the driver 222 is input to a second deserializer 224. The second deserializer 224 processes the received serial stream back into the parallel format. The responses, in the parallel format, are output to the initiator 200.

It should be appreciated that any suitable connection or coupling can be used for the channels 210 and 220. The channels may be provided by a wires, for example metal wires, optical interconnects or any other suitable connection environment or combination of two or more connection environments.

The request and the responses to the requests may comprise data, addressing information, control signals and/or instructions. At least part of the request and response may be in packet form. In other embodiments the data can be in any other suitable format. A signalling protocol may be used in some embodiments. For example, in one embodiment, a node sending data may send a valid signal and a node receiving data may send an associated acknowledgement signal. It should be appreciated that no protocol may be used and/or any other signalling protocol may be used in other embodiments.

In some embodiments the data is sent once the valid signal is high and the acknowledgement is confirmation of receipt of the data by the recipient. This valid/acknowledgement protocol may be used between the initiator and the first serializer 206/second deserializer 224 and between the target and the first deserializer 214/second serializer 216.

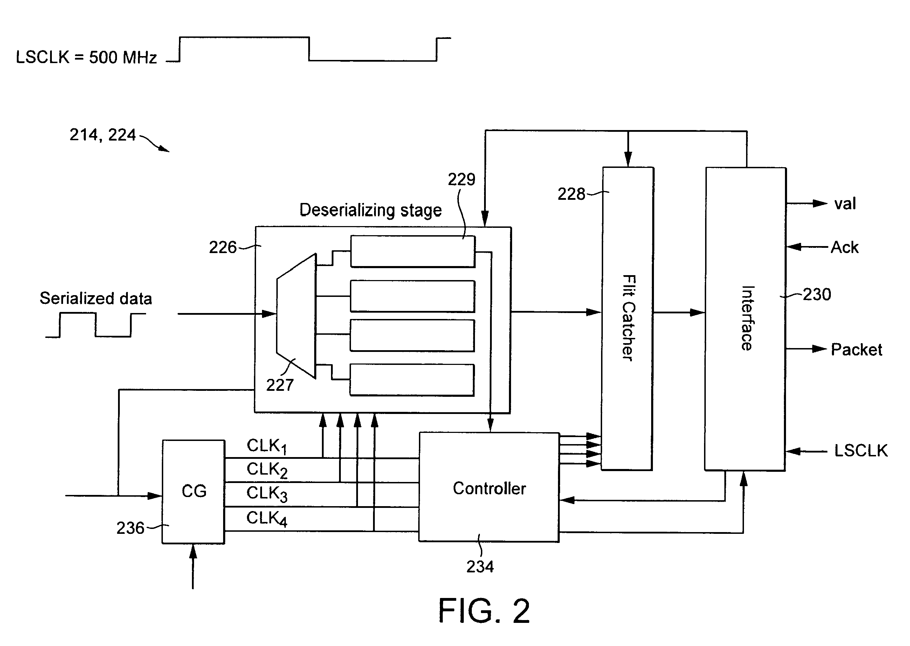

Reference is made to Figure 2 which shows the deserializer 214 or 224 in more detail. The serialised data is received by a deserializing stage 226. The deserializing stage has a demultiplexing arrangement 227 which divides the serialized data into the constituent channels which are deserialized by the registers 229. The output of the deserializing stage, in parallel format is loaded by a data catcher 228. The registers 229 are successively output into the data catcher which acts as a data buffer.

The output of the data catcher 228 is transferred to an interface 230 which will output the data in packet form. The interface 230 is also configured to implement the valid/acknowledgement protocol, generating the valid signal and receiving the acknowledgement signal. The interface receives a clock signal LSCLK which can be at any suitable frequency. By way of example only, the LSCLK may be at 500MHz. A four phase clock generator 236 is provided. The clock generator receives the output of a phase locked loop and generates four clock signals CLK1, CLK2, CLK3, and CLK4. The four clock signals have the same frequency but different phases. The four outputs of the clock generator 236 are input to the deserializing stage 226 and a controller 234. The controller receives an output from the deserializing stage 229 indicating when the data in the registers is ready for output and an output from the interface 230. The controller provides the four control signals to the data catcher 228 and provides a control output to the interface. The deserializing stage 226 also receives the output of the phase locked loop.

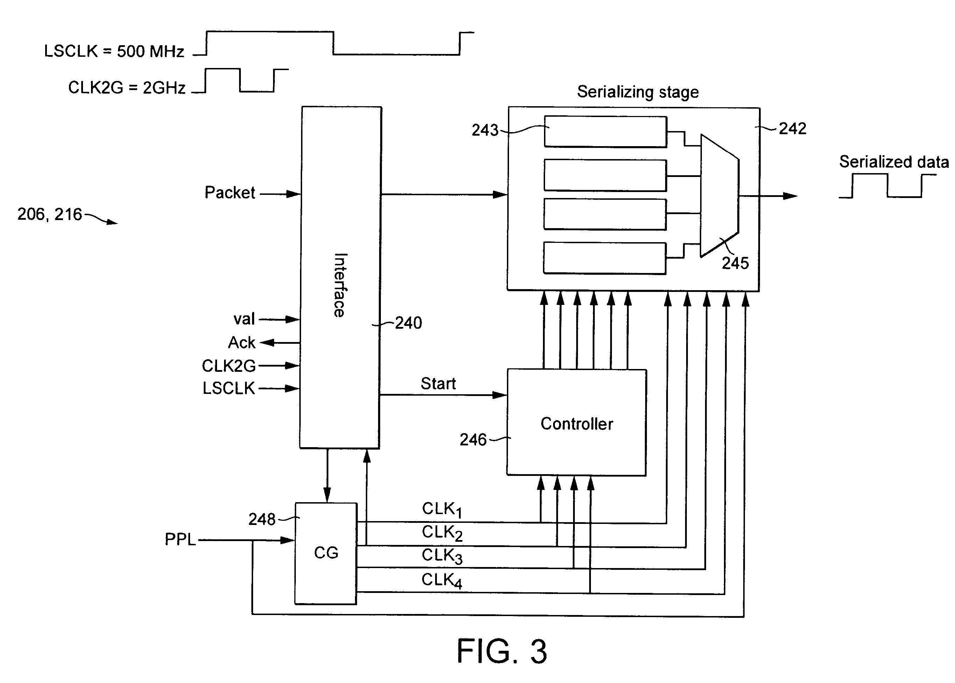

Reference is made to Figure 3 which shows the serializer 206 or 216 in more detail.

The data in parallel format is received by an interface 240. The interface 240 is also configured to implement the valid/acknowledgement protocol, generating the acknowledgment signal in response to receiving the valid signal. The interface receives a clock signal LSCLK which can be at any suitable frequency. By way of example only, the LSCLK may be at 500MHz. The interface 240 receives further clock signals CLK2G which can be any suitable value and in example is 2GHz.

The data in parallel format is output by the interface 240 to a serializing stage 242. The serializing stage 242 is a quad parallel in serial out shift register, inside which each register loads a quarter of the data and serializes it. The registers 243 are each connected or coupled to a respective input of a multiplexing arrangement 245 which serializes the constituent channels into a serialized data stream.

A four phase clock generator 248 is provided. The clock generator receives the output of a phase locked loop and generates four clock signals CLK1, CLK2, CLK3, and CLK4. The four clock signals have the same frequency but they are decayed each from the other by a 90 degrees phase shift.. The four outputs of the clock generator 248 are input to the serializing stage 242 and a controller 246. The clock generator receives an enable output from the interface 240. The controller provides the four clock signals to the serializing stage 242 and receives a start signal from the interface 240.

The serializer and the deserializer can be used in wired NoCs to address interconnect issues due to IC miniaturization such as wire congestion, electromigration and crosstalk.

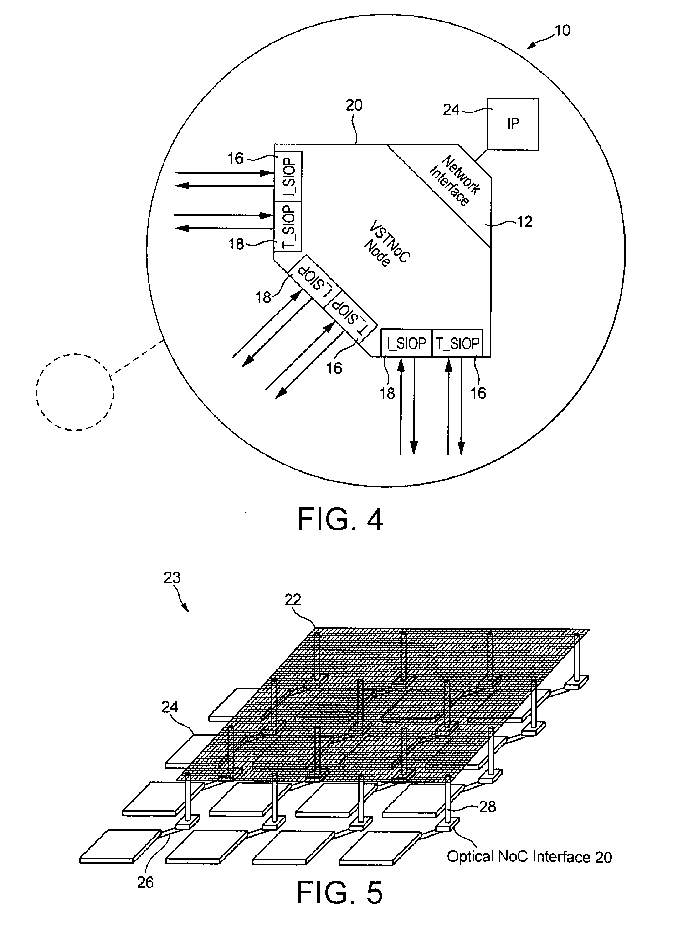

Figure 4 schematically shows a node of a wired network on chip NoC. The node 10 is a data router and is coupled via an electrical data communication connection to one or more functional blocks such as other similar routers and an IP block 24. The router is endowed with a network interface (NI) and one or more serial input/output ports (SIOP). The network interface is used to ensure the packetization and depacketization of data traffic, in addition to conventional IP interfacing with the node. In one embodiment, each port of the router utilises an initiator serial input/output port (I_SIOP) 16 and a target serial input/output port (T_SIOP) 18 to be able to support in two directions the initiator to target and target to initiator transactions given that target's data and initiator's data haves different sizes. The initiator's SIOP 16 ensures the serialization of the initiator's data and the deserialization of the target's data while the target's SIOP 18 is used to serialize the target data and deserialize the Initiator data. This may require four wires of copper to connect or couple two adjacent routers. Initiator and target data can circulate freely in any direction which offers the possibility of mounting the target and initiator on any node of the NoC. The data can reach its destination regardless the emplacement of the processing element. The data can reach its destination regardless the placement of the processing element. In some applications some channels may be dedicated to transport only one type of data. In other applications, but not all applications, initiators communicate with targets and vice versa but targets do not communicate with one another and/or initiators do not communicate with initiators. Thus, it may be possible for some, but not all embodiments, to reduce the area, power consumption and wires by omitting some SIOP ports.

In another embodiment, each port of a router uses a serializer to transmit data and a deserializer to receive it. In such a configuration, adjacent routers are linked with only two wires, each being used to transfer the serial data in one direction. Regardless on which router the initiator and/or target are mounted and regardless of the width of the data, the data can reach its destination. In some embodiments, this will reduce the circuit's area and/or the congestion of interconnect wires.

Aggressive scaling may result in severe limitations for the traditional high speed serial link. The copper wires used as an interconnect become long and consequently more parasitic which may affect the speed of the electric signals carrying data. This may contribute also to an increase in power consumption and/or a lack of synchronisation. When high bandwidth is required, another limit arises from the skin effect making the metallic connections a bottleneck in overall system performance. One alternative to the electric charge discharge channel is the optical interconnect. Such an arrangement is shown in Figures 5. It should be appreciated that embodiments can be used with wired, optical or hybrid optical/wired interconnects.

Figure 5 schematically shows an integrated circuit 23 representing a system on chip having an optical network on-chip.

The optical network on-chip node comprises processing elements 24 coupled to an optical NoC interface 20 with a wired channel 26. This interface integrates a serializer and a deserializer as well as laser drivers and photo diodes to convert electric signals into optic signals and vice versa. The processing elements 24 transfer their parallel data to the optical NoC interface 20 which loads the data in a secure manner, serialises the data and converts the generated electrical serial stream into an optical signal. The resulting optical signal is injected in an optical SOI waveguide. The waveguide is a scalable passive integrated photonic routing structure built with a set of microdisk resonators used as add-drop filters to switch the optical signals.

The physical architecture of the integrated circuit 23 of Figure 5 has an optical wavelength router 22 which is provided with a number of multiple wavelength optical data communication lines 28. Each of these multiple wavelength optical data communication lines 28 provides a connection or coupling between the optical wavelength router 22 and the optical network on-chip interface 20. At the receiving end the same optical NoC interface 20 performs the reverse operation by receiving the optical signal, converting that received signal into an electrical signal, deserializes the data and transfers the deserialized data to the processing elements 24.

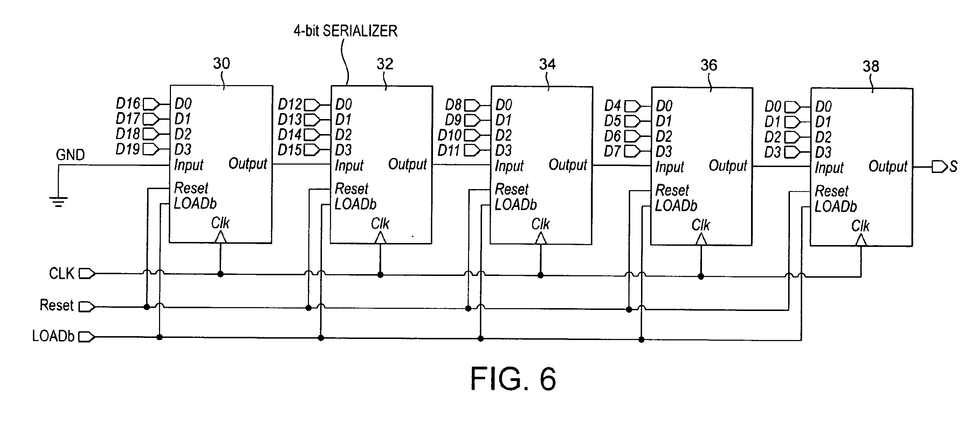

Reference is now made to figure 6 which shows one serialising stage 243 of the serialising stage 242 of figure 3. The serialising stage comprises first, second, third, fourth and fifth blocks 38. Each of these blocks is arranged to receive a clock signal at a clock input. The input of the first block 30 is connected or coupled to ground and the output of the first block 30 is connected or coupled to the input of the second block 32. Likewise, the output of the second block 32 is connected or coupled to the third block 34, the output of which is connected or coupled to the input of the fourth block. Finally, the last block is configured to receive the output from the fourth block 36 as an input and to provide an S output which is the serialised data.

The parallel data which is to be serialised is divided up into groups. In the example shown in figure 6, the data comprises 20 bits and accordingly, the data is divided into five groups of four bits. The first serializer receives bits D19 to D16, the second block 32 receives data bits D15 to D12, the third block receives data bits D8 to D11, the fourth block receives data bits D7 to D4 whilst the last block receives data bits D3 to D0. Each of the blocks 30 to 38 is arranged to receive a reset signal at a reset input thereof.

A LOADb signal is applied to a LOADb input of each of the blocks. The LOADb signal allows, when it is low to load fours bits into the blocks. When the LOADb is asserted, the loaded data start to propagate serially to the output.

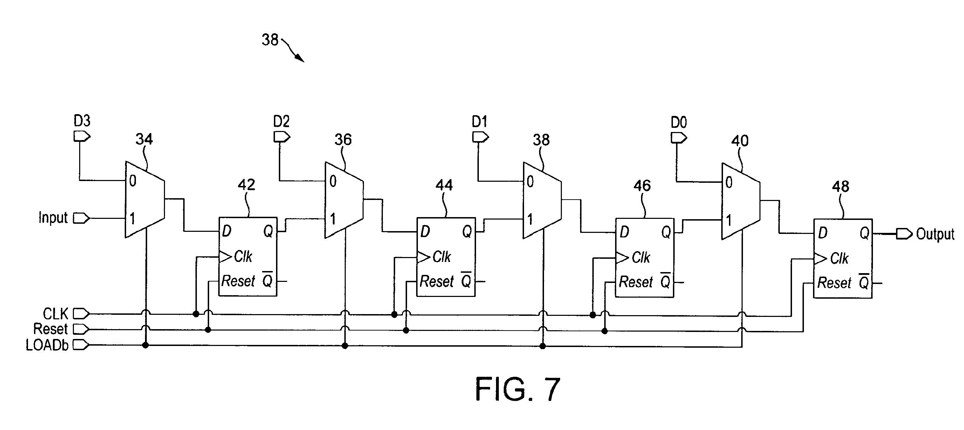

Reference is now made to figure 7 which shows one of the blocks of figure 6 in more detail. Each of the blocks has the same general structure. In this example shown, the fifth block 38 is shown. The block comprises a first flip-flop 42, a second flip-flop 44, a third flip-flop 46 and a fourth flip-flop 48. The block 38 also comprises a first multiplexer 34, a second multiplexer 36, a third multiplexer 38 and a fourth multiplexer 40. The output of the first multiplexer 34 is received at the D input of the first flip-flop 42. The output of the second multiplexer 36 is received at the D input of the second flip-flop. Likewise, the outputs of the third multiplexer 38 and fourth multiplexer 40 are respectively received at the D input of the third and fourth flip-flops 46 and 48.

The first flip-flop 42 is arranged to receive the fourth data bit D3 as an input along with the output of the previous block (or in the case of the first block 30 the ground signal). The second multiplexer 36 is arranged to receive the Q output of the first flip-flop. Likewise, the third and fourth multiplexers 38 and 40 are each arranged to receive the respective Q outputs of the second and third flip-flops 44 and 46.

Each of the multiplexers 34 to 40 is arranged to receive the LOADb signal as the control input. The reset signal is applied to the reset input of each of the flip-flops 48. Reset and LOADb signals are the pilot signals of this block.

Finally, each of the flip-flops 42 to 48 is configured to receive the clock signal at the clock input thereof.

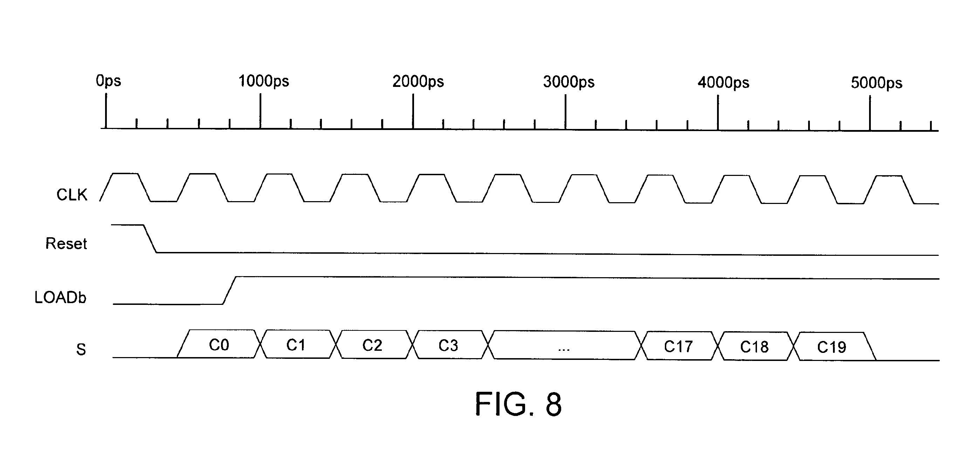

Reference is made to figure 8 which shows the timing associated with the arrangement of figure 6. Line 1 of figure 8 shows the clock signal. Line 2 shows the reset signal. Line 3 shows the LOADb signal and line 4 shows the output S of the fifth block 38 which represents the serialised data. The arrangement of Figure 6 is an active high reset four bit Serializer. Thus when the Reset signal is high all the flip flop are simultaneously reset and the arrangement of Figure 6 is deactivated. Initially, the Reset signal is high and LOADb signal is low. For a correct serialization operation, the data to serialize must be present at the input of the serializer. The operation starts by resetting the Reset signal midway during a clock cycle. Since the LOADb signal is still low when the reset signal first goes low and accordingly, the data on the data input of each multiplexer 34 to 40 is routed to the different flip flops 42 to 48 that capture them at the next rising edge of the clock.

After that data from the data input has been captured by the respective flip-flop, the LOADb signal goes high midway during the clock cycle. Thus, each of the multiplexers will now output the input from the preceding block in the case of the first multiplexer 34 and the Q output of the preceding flip-flop in the case of the second to fourth multiplexers. The data serialization mechanism begins by shifting the bits one by one at each rising edge of the clock. Effectively, this means that the output of the fourth flip-flop, in the case of the flip flop 48 shown in figure 7 will be the data in the following order; D0 D1 D2 and D3. This data will be clocked out in successive cycles. Further the data bits are clocked out of each block in succession to the next block which in turn output those data bits again in succession. In this way, the 20 bits of data are output serially as shown on the fourth line of figure 8, on successive clock cycles.

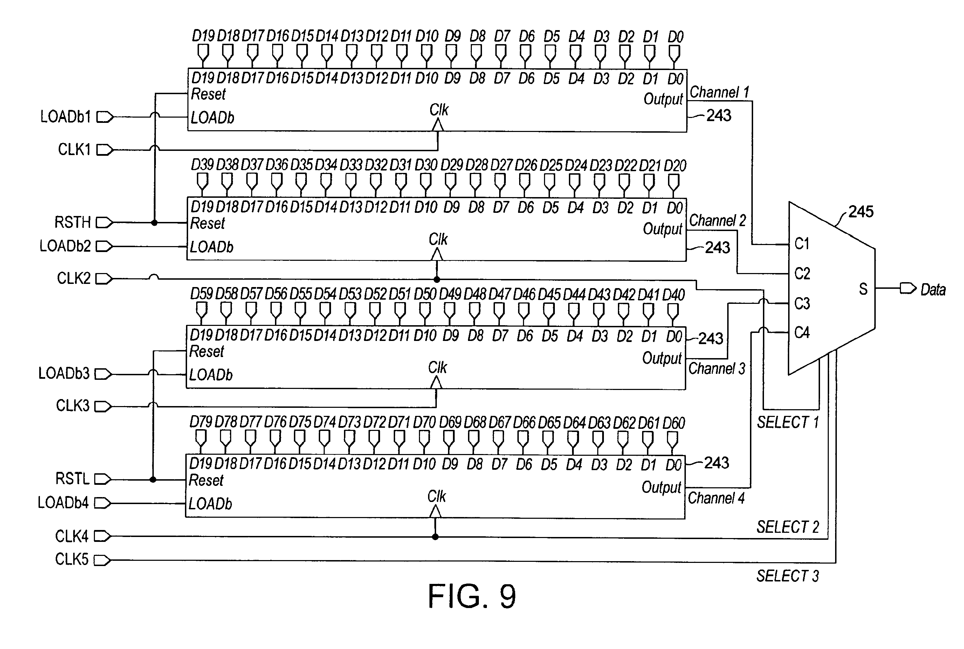

Reference is now made figure 9 which shows schematically four stages of the serializing stage 242 of figure 3. The serializer 242 comprises four serializing stages 243. Each of the serializing stages 243 is the serializing stage as shown in figure 6. As can be seen, the first serialising stage is clocked by the first clock CLK1, the second serialising stage is clocked by the second clock CLK2, the third serialising stage is clocked by the third clock CLK3 and the fourth stage is clocked by the fourth clock CLK4. These are the four clock signals generated by the clock generator 248 of figure 3. Each of the serialising stages is provided with a respective LOADb signal. Finally, the first and second serialising stages receive the same reset signal whilst the third and fourth serialising stages receive the same reset signal. In some embodiments four reset signals may be provided to control these serializing stages. However in some embodiments it is possible to share some reset signals between these stages in order to reduce the number of pilot signals and hence simplify the design of the controller. The output of each of the serialising stages comprises the serialised data which is input to the multiplexer 245. The multiplexer receives as control signals the second clock signal, the fourth clock signal and the fifth clock signal which is the inverted signal of the PLL.

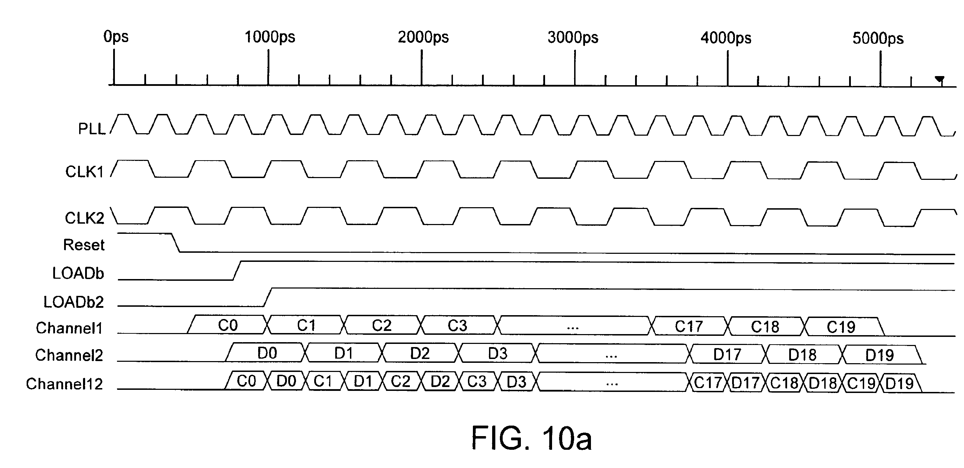

Reference is made to Figure 10a which show a timing diagram associated with the multiplexer 245. The first line shows the PLL clock signal, whilst the second and third lines show the first and second clock signals CLK1 and CLK2, which are 180 degrees out of phase. The fourth line shows the Reset signal whilst the fifth and sixth lines show the respective LOADb signals for the first and second serialising stages. The seventh and eighth lines show respectively the serialised data output by the first and second channels. The multiplexer 245 may comprises a first multiplexer for combining the output of the first and second serialising stages, a second multiplexer for combining the output of the third and fourth serializing stages and a third multiplexer for combining the outputs of the first and second multiplexers. The last line shows the output of the first multiplexer which has combined the first and second channel data.

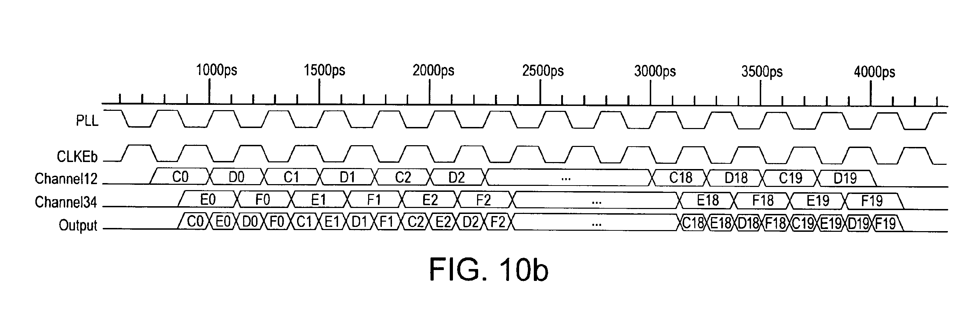

The relationship between the first clock signal CLK1, the reset signal, the LOADb signal for the first serialising stage and the channel 1 data (S output) has already been explained with reference with Figure 8. It should be appreciated that there is a similar relationship between the second clock signal CLK2, the reset signal, the LOADb signal for the second serializing stage and the second channel data. The final line of Figure 10a shows the output of the first multiplexer where the first and second channel data is combined. The first multiplexer is controlled by the second CLK signal CLK2 to scramble the first and second data channel into a single serial data channel. There a similar relationship between the third clock signal CLK3, the associated reset signal, the LOADb signal for the third serializing stage and the third channel data. Finally there here is a similar relationship between the fourth clock signal CLK4, the associated reset signal, the LOADb signal for the fourth serializing stage and the fourth channel data. The output of the second multiplexer provides the combined third and fourth data output which is shown in the fourth line of Figure 10b. The second multiplexer is controlled by the CLK4 signal to scramble the third and fourth data channel s into a single serial data channel.

Figure 10b shows the PLL clock signal and its inverse (CLK5b) on lines 1 and 2. The third and fourth lines respectively show the combined first and second channels and the combined third and fourth channels. The final line shows the combined first to fourth channel output provided by the third multiplexer which has the inverse of the PLL clock signal as the control signal.

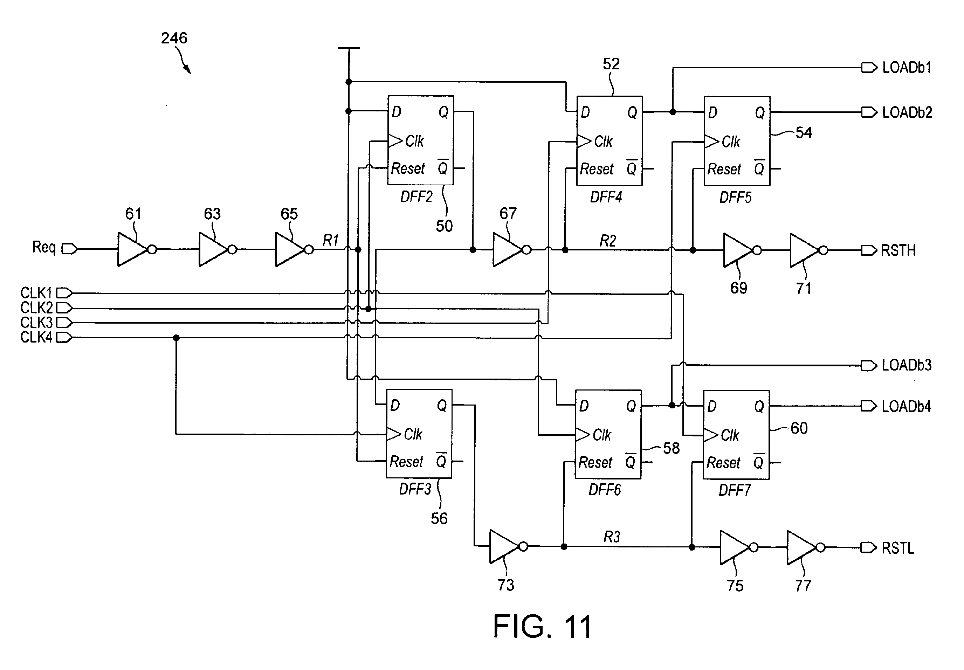

Reference is now made to figure 11 which shows the controller of 246 of figure 3 in more detail. The controller comprises six flip-flops 50, 52, 54, 56, 58 and 60. The first flip-flop has a D input connected or coupled to a high voltage supply i.e. a voltage supply providing a logic "1" level. It should be appreciated that this also provides an input to the second flip-flop 52 and the fifth flip-flop 58. The first flip-flop receives a clock input from the CLK2 clock signal. The reset input is provided by the output of an inverter chain which comprises first, second and third inverters 61, 63 and 65. A request (or valid) signal is input to the first inverter and is output by the inverter chain, in inverted form, as a reset signal. The Q output of the first flip-flop is output to the D input of the fourth flip-flop 56 and is also input to a fourth inverter 67. The output of the fourth inverter 67 provides the reset input for the second flip-flop 52 and the third flip-flop 54.

The second flip-flop 52 is arranged to receive a clock signal from CLK3. The Q output of the second flip-flop 52 is input to the D input of the third flip-flop 54 and also provides the first load output LOADb1.

The third flip-flop 54 provides the second load signal LOADb2 at its Q output. The third flip-flop 54 is arranged to receive the fourth clock signal CLK4 as the clock input.

It should be noted that the output of the fourth inverter 67 is input to a second inverter chain comprising inverter 69 and inverter 71. The output of the second inverter 71 of the second inverter chain provides a RSTH signal which is the reset signal for the first and second serializing stages.

The fourth flip-flop 56 is arranged to receive a clock signal from the fourth clock signal CLK4. The Q output of the fourth flip-flop 56 is input to an inverter 73 the output of which provides the reset signal for the fifth and sixth flip flops 58 and 60. The output of the inverter 73 is input to a third inverter chain comprising inverters 75 and 77. The output of the second inverter 77 of third inverter chain provides the RSTL signal which is the reset signal for third and fourth serializing stages. The clock signal of the fifth flip flop 58 is provided by the second clock signal CLK2. The Q output of the fifth flip-flop 58 is input to the D input of the sixth flip-flop 60 and also provides the third load signal LOADb3. Finally, the sixth flip-flop provides at its Q output the fourth load signal LOADb4.

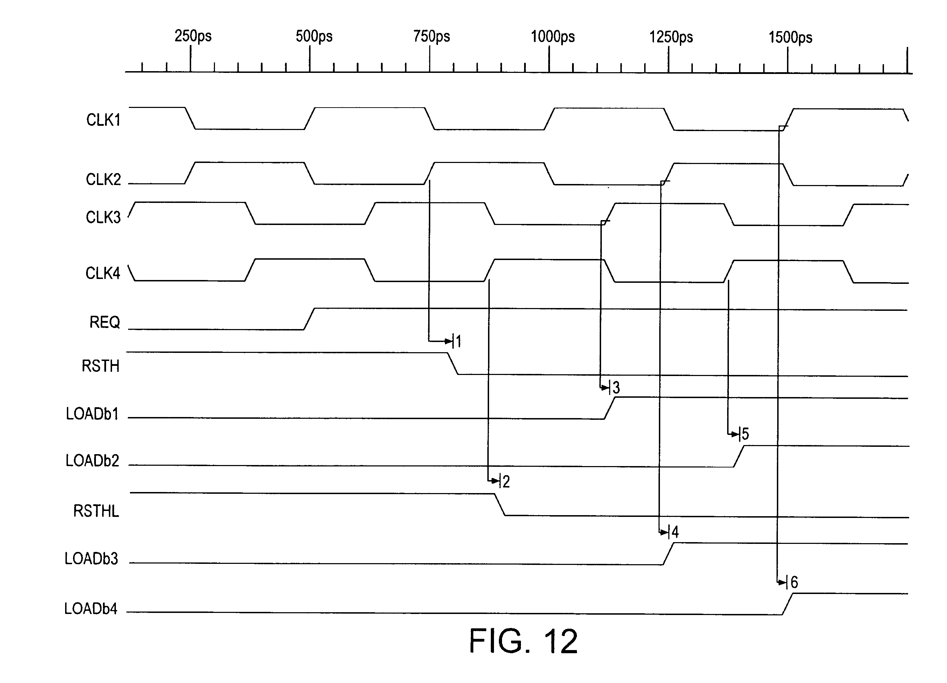

Reference is now made to figure 12 which shows the timing diagram associated with the controller of figure 11. The first line of the timing diagram shows the first clock CLK1, the second line shows a second clock CLK2, the third line shows the third clock CLK3 whilst the fourth line shows the fourth clock CLK4. As can be seen from figure 12, each of the four clocks has the same frequency but is shifted in phase with respect to each other. In particular, CLK1 and CLK2 are 180° out of phase with respect to each other whilst CLK3 and CLK4 are 180° out of phase with each other. Likewise, there is a 90° phase difference between each of CLK1 and CLK2 with each of CLK3 and CLK4 (plus or minus 90°).

The fifth line shows the request (or valid) signal. The sixth line shows the RSTH signal whilst the seventh and eighth lines show LOADb1 and LOADb2 respectively. The ninth line shows the RSTL signal which is followed respectively by the LOADb3 signal and the LOADb4 signal. Once the request signal goes high, the next rising edge of the second clock signal CLK2 causes the signal RSTH to go from high to low. Accordingly, the next rising edge of the third clock signal CLK3, after the RSTH signal has gone low causes the LOADb1 signal to go high. The LOADb2 signal will go high after LOADb1 signal has gone high but on the next rising edge of the fourth clock signal CLK4.

When the request signal is low, this provides a high output at the output of the first inverter chain keeping the first flip-flop and hence the rest of the flip-flops in a reset state. When the request signal goes high, this means that the reset state is removed from the first flip-flop and accordingly the high value on the D input is propagated via the inverter 67 to provide a low reset input to the second and third flip-flops. This allows the second flip-flop 52 to propagate the high value to its Q output thus providing the first LOADb1 signal. The first LOADb1 signal is input to the third flip-flop 54 which provides the second LOADBb2 signal which is why the LOADb1 signal is earlier than the second LOADb2 signal. The first LOADb1 signal is clocked by the third clock signal CLK3 whilst the second LOADB2 signal is clocked by the fourth clock signal CLK4. It should be appreciated that the low output from inverter 67 is propagated through the last inverter chain 69 to 71 to take the RSTH signal to low. When the REQ signal is low the Q output of the first flip-flop 50 is also low. This means that the output of the inverter 67 is high which means that both of the second and third flip-flops are in the reset state and that the output of a second inverter chain is high.

Similarly, when the request signal is high, the fourth flip-flop 56 has a high signal received at the reset input thus putting that flip-flop into a reset state. The output of that flip-flop is low which means that the output of the inverter 73 is high again putting the fifth and sixth flip-flops 58 and 60 into a reset state. The fifth and sixth flip-flops 58 and 60 operate in an analogous way to the second and third flip flops but using clock signals CLK2 and CLK1 respectively. This means that the LOADb3 signal is provided in a similar manner to the LOADb1 signal whilst the LOADb4 signal provided in a similar manner to LOADb2. The output of third inverter chain provides the RSTL signal.

In some embodiments of the present invention, the serialisation may be less quick than the incoming parallel data rate. Synchronisation needs to be taken into account when targeting best performance. Frequently, there may be an initiator/target exchanging data in a burst mode of operation. If the serialisation speed is increased, this may have disadvantages of high noise, high power consumption, require specific high speed technology and require high speed PLLs. Some embodiments may provide a way of controlling the data rate and prevent data loss or duplication. Some embodiments may use dual clocking and a low power technique. Some embodiments may provide a dual, clock interface that supports a pseudo-synchronous handshake protocol to ensure flow control and thus avoids the loss or duplication of data. The interface may be arranged to support a data bust mode without data loss. The interface is arranged to communicate with the serialisation stage. Automatic gating control may be provided. N fold data holders such as N fold flip-flops may be partially activated.

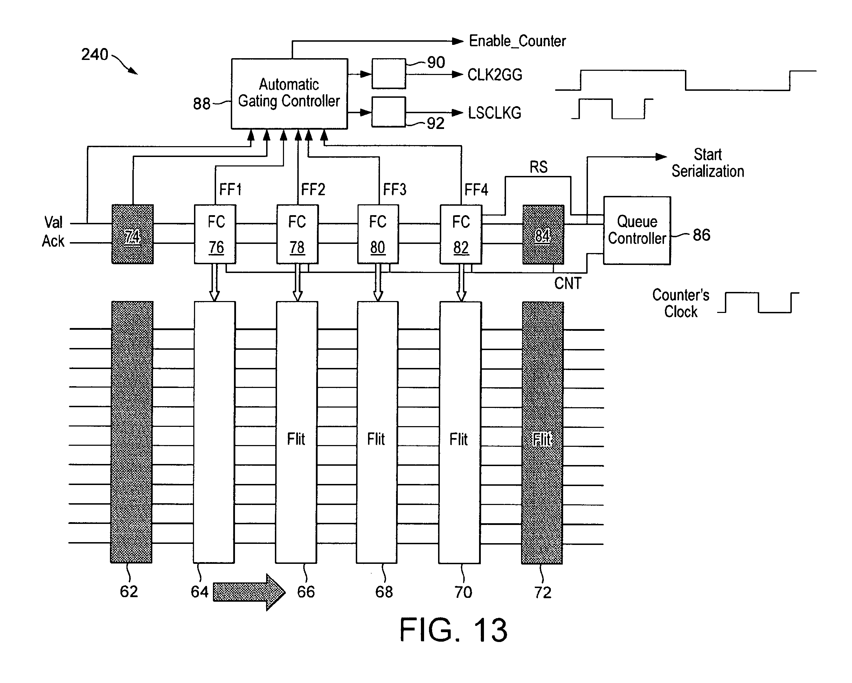

Reference is made to figure 13 which shows an embodiment of the invention. The arrangement shown in figure 13 comprises the interface 240 of figure 3.

The interface comprises, in the example shown in figure 13 six data stores, 62, 64, 66, 68, 70 and 72. The first data store 62 has N inputs which comprise the parallel data which is received either from the initiator or the target. The first data store 62 has n outputs which allow data to be shifted to a second data store 64.

Likewise, the output of the second data store 64 can be shifted to the third data store 66 and so on. The second, third, fourth and fifth data stores each have a respective controller 76, 78, 80 and 82. A first controller 74 is provided which is arranged to receive a valid (request) signal from the source of the packet. In response to that request, the first controller provides an acknowledgement signal ACK which is returned to the source of the packet. The valid signal is input to an automatic gating controller 88. The controller 74 is also arranged to provide an output to the automatic gating controller. The first flow controller is arranged to send the received valid signal to the second controller 76 which is arranged to provide the ACK signal to the first flow controller. Likewise, the second controller 76 is arranged to output the valid signal to the third controller 78 which outputs the valid signal to the fourth flow controller 80 and so on until the valid signal is received by the sixth flow controller 84. The sixth flow controller 84 outputs the ACK signal to the fifth controller 82 which outputs the ACK signal to the fourth flow controller and so on until the ACK signal is output by the second controller 76 to the first controller 74. The second, third, fourth and fifth controllers are arranged to control the respective data stores. In particular, these controllers control whether or not the clock signal which is provided to the respective data store is gated or not. Thus, if there is no need for data to be received from a preceding data store or output to a succeeding data store, that is the data state is held, then no clock signal is applied to the data store, thus saving power.

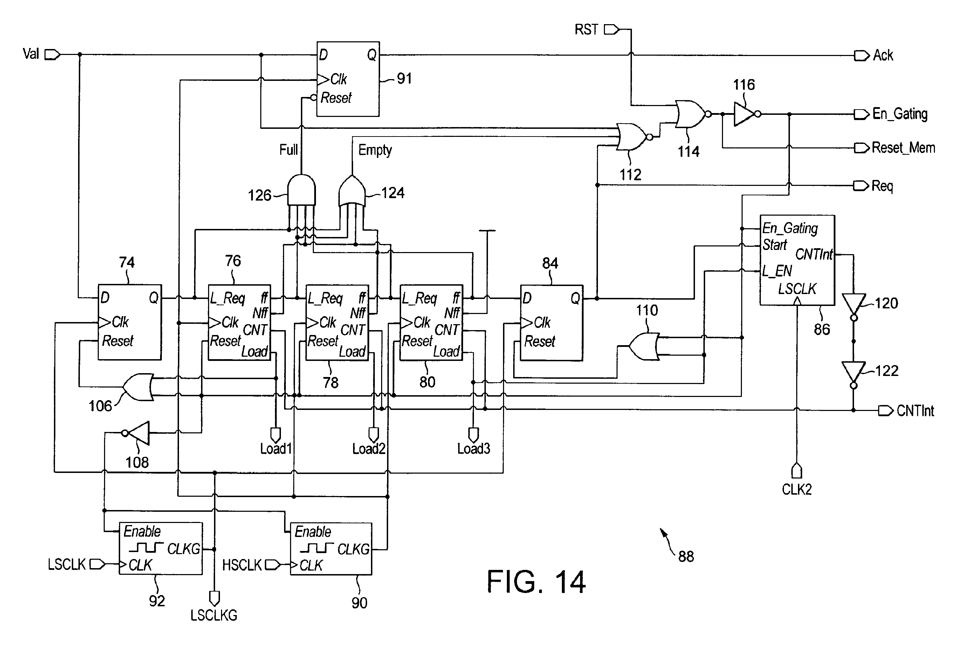

The data store can take any suitable format but may comprise an N fold flip-flop. When no clock signal is to be applied to the N fold flip-flop, a low logic level signal will be applied to the respective clock inputs of the flip-flops of the N fold flip-flop. The second to fifth controllers 76, 78, 80 and 82 are also configured to provide outputs to the automatic gating controller. These signals will be discussed in more detail with reference to Figure 14. A queue controller 86 is provided which has a control output which is input to each of the second to six flow controllers. The bank registers 62 and 62 are permanently clocked by the gated LSCLK clock.

When the valid signal is logic high, the automatic gating controller 88 is configured to output via a first clock gating cell 90 a first clock signal and via a second clock gating cell 92 a second clock signal. The first clock signal has a first frequency which is relatively high and may for example be 2GHz. The second clock signal is relatively low and may be for example 500 MHz. Further, the automatic gating controller is configured to generate an enable signal for enabling the clock generator 248 The first controller 74 then outputs the valid signal to the automatic gating controller when the data is loaded in the first data store.

The RS signal from the fifth controller 82 to the queue controller is the signal responsible for the reset of the counter. The queue controller 86 provides an output control signal CNT.Reference is now made to figure 14 which shows the controlling parts of the circuitry of figure 13. The first flip-flop 74 comprises the first controller 74. The blocks 76, 78 and 80 are the second, third and fourth flow controllers shown in figure 13. To simplify the arrangement, the fifth flow controller 82 is not shown.

The first flip-flop 74 is provided as the first controller. The first flip-flop 74 receives a D input from the valid signal. The first flip-flop 74 has a clock input provided by the output of the clock gating cell 92. This provides the clock signal LSCLKG as an input. The first flip-flop 74 has a reset input provided by the output of a first OR gate 106. The Q output provides an input to the L_{req} input of the second controller 76.The second controller 76 provides a first load output LOAD1 which controls whether or not the clock signal is applied to the associated data store. This load output is connected or coupled to the input of the first OR gate 106 along with a second input provided by the output of a first inverter 116 which comprises an enable gating signal. If one or other of these signals provided to the first OR gate 106 is high, a reset signal will be applied to the flip-flop 74.

The second controller 76 is arranged to receive a clock signal from the first clock gating cell 90 as is the third and fourth controllers 78 and 80. The enable gating signal form the inverter 116 is provided as a reset signal to the second, third and fourth controllers 76, 78 and 80.

The load output of the third controller 78 comprises the load signal applied to the associated data register whilst the fourth controller 80 provides a load control output for the associated register. Each of the second to fourth controllers 76, 78 and 80 is arranged to receive a control output which is output by queue controller block 86. The output from the queue controller block 86 is input to a first inverter chain comprising first inverter 120 and second inverter 122 before being output to the respective controllers.

The ff output of the second controller is input to the L_{req} input of the third controller. Likewise, the ff output of the third controller is input to the L_{req} input of the fourth controller. The ff output of the fourth controller is input to the flip-flop 84 providing the fifth controller in the arrangement of the figure 13. The Nff output of the fourth controller 80 is connected or coupled to a logic level 1.

The enable gating signal is passed via an inverter 108 to the enable inputs of each of the clock gating cells 90 and 92. The clock gating cell 90 receives the high speed clock CLK2G as a clock input to thereby provide a gated clock output CLK2GG. Likewise, the second clock gating cell 92 receives the low speed LSCLK to provide a gated clock output LSCLKG.

The flip-flop 84 has a clock input provided by the low speed clock LSCLKG. The reset signal is provided by the output of an OR gate 110 which has a first input connected or coupled to the enable gating signal and a second input connected or coupled to the Load output of the fourth controller 80. This controls if the flip-flop 84 is to be reset. The Q output of the flip-flop 84 is provided to the start input of the queue controller 86 and provides a request signal REQ which is provided to controller 246 as discussed previously. The Q output of the flip-flop 84 is also provided to a NOR gate 112 which has a second input connected or coupled to the valid signal and a third input connected or coupled to an OR gate 124. The OR gate 124 receives the Q output of the flip-flop 74, the ff output of the second controller 76, the ff output of the third controller 78 and the ff output of the fourth controller 80.

The output of the NOR gate 112 is input to a second NOR gate 114 which receives a reset signal as a second input. The output of the second NOR gate 114 is input to the inverter 116, which provides at its output the enable gating signal. The output of the second NOR gate 114 provides a reset MEM signal. This signal is tied to all the Reset inputs of the data store registers

An AND gate 126 has four inputs. The inputs are provided by the Q output of the flip-flop 74, the ff output of the second controller 76, the ff output of the third controller 78 and the ff output of the fourth controller 80.

A second flip-flop 91 is provided as part of the automatic gating controller 88 which receives the valid signal as a D input. The clock input is provided by the output of the first clock gating cell 90 which provides the first clock signal CLK2GG. The reset input is provided by the output of the AND gate 126 and the Q output provides the ACK signal.

The registers 62 to 72 of the queue serve to hold data. The validity of this data is indicated by the flag signal of the register's associated controller 74 to 84. If a register of the queue is empty, its associated controller indicates that by holding this flag to 0 logic. When a register of the queue holds valid data the flag of the associated controller holds a 1 logic. Of course in an alternative, a 1 logic may indicate an empty register while a 0 logic may indicate data in a register.

For the first and last register of the queue this flag is the output signal of the flip flops 74 and 84. For the others registers this flag is the output signal of the ff output of the respective controller 76 to 80. The controllers 76 to 80 implement a micro pipeline for automatic partial clock gating of the registers. Adjacent controllers are connected or coupled together to communicate with each other using a synchronous req/nack handshaking protocol for synchronization. Each controller functions according to the state of the previous, current and the next stage registers of the interface. Based on these indications, a controller decides whether or not to trigger the stage which it controls by enabling its clocking. This means only some registers of the queue may be clocked which may help reduce the switching activity in the interface.

A controller has two modes of operation depending on the state of the input signal CNT. When CNT is high a controller operates in normal mode during which a local enable gating signal Load is produced by the controller to activate the local clock if the register is empty and the input receives valid data or if the register is full and is to output the data to the input of an empty next register. When CNT is low the controller operates in shifting mode. This mode allows the clocking of the registers as in the normal mode but also the clocking of full registers the outputs of which are input to a full next register.

The RST Signal is the general asynchronous active high reset of the Serializer. When RST is high, the Reset_Mem signal is low and the En_Gating signal is low. The Low Reset_Mem causes the resetting of all the registers of the queue to empty the queue. The high En_Gating signal causes the reset of the controllers 76 to 80. The output of both the OR gates 110 and 106 are high which resets the flip flops 74 and 84. As a consequence, all the flags of the controllers of the queue's registers are low forcing the AND gate 126 and the OR gate 124 that receives all these flags (except for the flag of the flip flop 84) to the low state. The outputs of these gates provide the interface with useful information. When the queue is full, the AND gate 126 outputs a 1 logic and deactivates the flip flop 91 to provide a low Ack signal to the initiator. When the queue is empty the OR gate 124 outputs a O logic.

The high En_Gating signal feeds the input of the inverter 108. The output of the inverter 108 is low so that the two glitch free clock gating cells 90 and 92 are disabled and the clocks LSCLK and CLK2G are not passed to their outputs. The high En_Gating signal deactivates also the four phase clock generator 248 to prevent the generation of the clocks CLK1 to CLK4 as well as deactivating the queue controller 86. Thus, when the serializer is deactivated no dynamic power is consumed since all the clocks needed to operate the serializer are deactivated.

To activate the serializer, the RST signal has to be changed to a low state. Initially the queue of the interface is still empty which is indicated by output of the OR gate 124 remaining low. When the valid signal is low, the NOR gate 112 will have a low input from the valid signal, a low input from the OR gate 124 and a low input from the output of the flip-flop 84. The output of the NOR gate 112 will thus be high. The second NOR gate 114 will also receive a low input from the reset signal and as such will provide a low output. Hence, Reset_Mem is low and the Enable_Gating is high as if the RST signal was high. All the internal clocks of the serializer are deactivated and the serializer is in sleep mode. Accordingly, no dynamic power is consumed. The Serializer remains in the sleep mode as long as there no request for data serialization is received from the sender.

The Val signal serves to wake up a Serializer in sleep mode. When data is ready at the input of the interface, the Valid signal Val become high. This forces the output of the NOR gate 112 to low and provides a signal at a high state at the output of the second NOR gate 114. The Reset_Mem signal is high and the En_Gating signal becomes low. The high Reset_Mem signal activates the queue's registers while the low En_Gating signal activates all the controllers 74, 76, 78, 80 and 84 of the registers as well as the four phase clock generator 248, the Queue controller 86 and the glitch free clock gating cells 90 and 92. The LSCLK and the CLK2G are enabled and all the internal clocks needed for serialization reaches the blocks of the serializer. The first and last register of the queue are permanently clocked with the LSCLKG clock signal provided by the output of the glitch free clock gating cell 92. The CLK2GG clock provided by the output of the first glitch free clock gating cell 90 serves to synchronizes only the controllers 76, 78 and 80 as well as the flip flop 91.

The first rising edge of the LSCLKG clock signal will cause the loading, into the first register of the queue, of the data provided by the sender. It also causes the sampling of the Valid signal by the flip flop 74. The output of the flip flop 74 becomes high indicating that the first register holds valid data. At the same time, the first rising edge of the CLK2GG makes the flip flop 91 copy the high Val signal and output a high Ack signal. This high Ack signal is used as an acknowledgement signal and is sent to the sender of the data to indicate that the data has been correctly loaded by the interface. In the second clock cycle of the CLK2GG, both the ff and Load outputs of the controller 74 go to high. The load signal serves to enable the gating of the second register of the queue making that register load the data output by the first register of the queue. The high ff indicates that the second register, at this time, holds valid data. Gating the CLK2G clocks for the register using the Load signal as an enable signal can be done, for example, in two ways. The first is to AND the Load signal with the CLK2GG clock and use the resulting signal as a clock signal for the respective register concerned by the data. The second is to provide directly the load signal as a clock signal to the respective register if the CLK2GG frequency is more than three times the frequency of LSCLKG. In some embodiments, the second method mitigates the area of the interface and reduces further the static power consumption by eliminating the need to use some AND gates to gate the CLK2GG clocks for the queue's registers. If the Val signal goes to low the Serializer remains in Wake mode since the ff signals of the controller 76 forces the OR gate 124 to high and consequently the Reset_Mem signal remains high while the En_Gating signal remains low.

Being high at the first cycle of CLK2GG, the Load signal forces the OR gate 106 to output a 1 logic which resets asynchronously the flip flop 74. This helps to prevent the reading of the same data in the next CLK2GG cycle and hence avoid data duplication. This way, the data crosses the frequency domains without being duplicated. The first domain is a low speed domain clocked by LSCLK while the second domain is the high speed domain clocked CLK2GG.

At the second rising edge of the CLK2G, both outputs of the controller 76 go to low since the L Req and Nff inputs were low in the previous clock cycle. The flip flop 74 is again enabled which allows the reading of different data but in the next rising edge of LSCLKG. The rising edge of the clock CLK2G will also result in the transfer of the valid data to the third register by the third controller 78. The third controller functions as the previous controller 76 in the previous clock cycle. The first received data continues to propagate through the queue according to the described principle until the first received data reaches the controller 80 where it stalls. In the high speed domain clocked by CLK2GG, the shifting of the received data inside the queue is accelerated in order to reduce the latency and eventually improve the performance of communication since data latency may be proportional to the queue depth. Other data can be received by the interface and propagated through the queues simultaneously without being duplicated. The micro pipelining implemented with the controllers 76 to 80 prevents frozen data being erased by stopping the data at the last empty register of the queue.

The data stored by the register controlled by the controller 80 is stalled until the next rising edge of the LSCLKG clock that causes the movement of this data from this register to the last register of the queue. At the same time, the flip flop 84 outputs a 1 logic indicating that the operation has started and/or data is being serialized. This means that the Req signal become high which enables the serializer's controller 246 to start the generation of the control signals for the serializing stage 242. The same signal Req serves as a start signal for the queue controller 86 making that queue controller start the operation of bit counting. The data is serialized and this operation ends when the incremental counter integrated inside the queue controller reaches the value which is equal to the number of bits of the data. Once this value is attained, the CNT output of the queue controller 86 goes low forcing the controllers 76, 78 and 80 to function in shifting mode for one CLK2GG cycle during which all the data of the queue is shifted at the same time. This serves to prepare the next data to be serialized by erasing the data of the register controlled by the controller 80 with the data that was held by the register controlled by register 78.

When the controller 80 asks the associated register to load the next data by setting the Load output to high, this signal resets the incremental counter of the queue controller 86 and the flip flop 84. Thus the CNT output of the Queue controller goes back to the high state bringing the controller 76, 78 and 80 again to their normal mode of operation. Since the Nff input of the controller 80 is tied to VDD, the next rising edge of the CLK2GG cycle will cause the Load output of the controller 80 to go to low state. This enables again both the queue controller and the flip flop 84 since the output of the OR gate 110 become a 0 logic. The next data is now ready and its serialization will start at the next LSCLKG clock cycle when the data is loaded by the last register of the queue.

All the data hold by the registers will be shifted, read and serialized according to the same principle until the Queue is again empty. As long as the queue of the interface is not completely empty, the request signal Val is low or data is being serialized, the En_Gating signal remain high forcing the serializer to be in a wake mode. Conversely if the queue becomes empty, no data is being serialized and the Val signal is low, the enable gating signal becomes high and the serializer goes again into the sleep mode. In the wake mode, the interface can receive continuously data from the sender. In a burst mode data transfer, since the data rate coming from the sender is more key than the serializing speed, the queue may be completely filled with data. In such a situation, the AND gate 126 outputs a 1 logic indicating a queue overflow. This signal disables the flip flop 91 and resets asynchronously its output ACK. Hence the sender is informed that the serializer is not ready to receive new data. The Sender will not send any more data until it receives a high Ack signal. This may prevent data losses during the transfer of data from the sender to the interface. This pseudo synchronous method may be useful to circumvent the problem of data loss due to the limited capacity of the interface's queue to hold data.

When the queue of the interface is not completely full and the Val signal is maintained high for burst mode data transfer, at each LSCLKG clock data is loaded into the queue of the interface at the speed of the sending node and the ACK signal is maintained high since the Val signal is copied. Thus the sender receives acknowledgements and can send another data in the next clock cycle. If the sender has no more data to transfer to the interface the Val signal goes low and systematically the ACK signal goes to low at the rising edge of the CLK2GG. The serializer continues to function as described above. If no other data is received from the sending node during the serialization of the data stored in the queue, the En_Gating signal goes high when all the data of the queue has been serialized. This disables all the internal clocks of the serializer and puts it into the sleep mode.

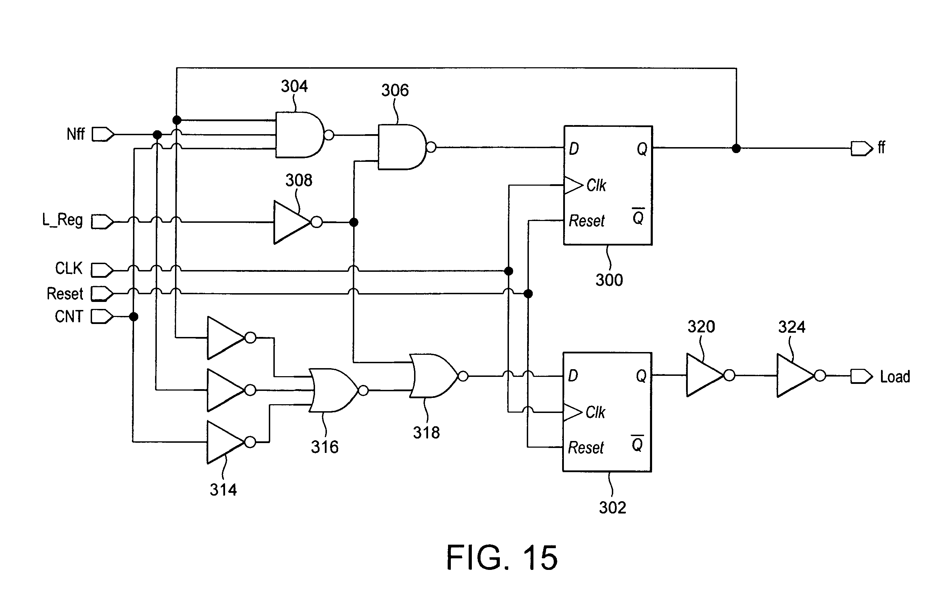

Reference is made to Figure 15 which represents the blocks 76, 78 and 80 shown in Figure 14. The arrangement shown in figure 15 provides a controller which allows communication with similar neighbouring blocks using a pseudo-synchronous handshaking protocol data flow control which may avoid data obliteration. A controller output automatically provides an enable signal for the gating cell to prevent unnecessary gating of for example of the n fold flip-flop. The decision is calculated according to the request of the source stage, its own state as well as the next stage state. The arrangement which will be described has a small area and relatively low power consumption. In some embodiments, such an arrangement can be used to implement a relatively low power FIFO, pipeline and queuing elements for networks on chip and/or low power interfaces. Some embodiments may save power where there is an absence of data to be held.

The arrangement shown in figure 15 comprises a first NAND gate 304 which arranged to receive a first input from the Q output of a first flip-flop 300. The NAND gate receives a second input Nff (NNF is the full flag of the next similar controller) and a third control input CNT. The CNT signal is used to force the controller to enable the gating of the corresponding n fold flip flop. This input allows the selection between the normal mode and the shifting mode of the controller. The output of the first NAND gate 304 is provided to a first input of a second NAND gate 306. The second NAND gate 306 receives an input from the output of a first inverter 308 which receives L_{Req} signal The output of the first inverter is also connected to a second NOR gate 318. The other input to the second NOR gate 318 is provided by the output of a first NOR gate 316. The NOR gate 316 receives three inputs respectively from a second inverter 310, a third inverter 312 and a fourth inverter 314. The second inverter 310 receives the Q output of the first flip-flop 200. The third inverter 312 receives the Nff input whilst the fourth inverter receives the control input CNT.

The output of the second NAND gate 306 is provided to D input of the first flip-flop 300. The clock input of the first flip-flop 300 receives the clock signal and the reset input is connected to the reset signal.

A second flip-flop 302 is provided which receives the output of the second NOR gate 318 as its D input. The clock input receives the clock signal and the reset input is connected to the reset signal. The Q output of the first flip-flop provides the ff signal. The ff signal is the full flag indicator. When the n fold flip flop controlled by this controller holds a valid data the ff signal is maintained to high state, else the signal is maintained at a low state.

The Q output of the second flip-flop is provided to a sixth inverter 320 the output of which is provided to a seventh inverter 324. The inverters form a buffer used to strengthen the effort of the output of the flip flop 302.The output of the seventh inventor provides the load signal. It should be appreciated that the load request signal L_{Req} comprises the Q output in the case of the flip-flop 74. In the case of the controllers 78 and 80, the load request signal comprises the ff output of the preceding controller.

The arrangement shown in Figure 15 is used to control a data register of n bits. In an initial condition, the load output is low, the LReq request signal is low (indicating that there is no data in the preceding register), CNT is high (for normal mode operation) and the current register does not hold valid data. This means that the ff signal of the current controller is at low state. The output of the NAND gate 304 is then at a high state and the outputs of the NAND gate 306, the NOR Gate 316 and the NOR gate 318 are at a low state. Thus, at each clock cycle and provided that LReq signal remain low, the ff and the Load outputs of the controller outputs a 0 logic. The register is not clocked and the controller continues to indicate that the corresponding register does not holds valid data.

The LReq signal passes to a high state to indicate the presence of valid data at the input of the current register. This makes the NAND gate 306 and the NOR gate 318 output a 1 logic. The rising edge of the clock signal will cause the transition from low to high of both the ff and Load signals. The clock gating of the register is enabled letting the register load the data at its input which validity is indicated by the ff signal being held at the high state. This signal is also used as a LReq signal for the next register stage controller.

Consider the following three cases. In the first case, the next register is holding valid data. The ff flag of this next controller is used as an Nff input for the current controller. In this situation NAND gate 306 outputs a 1 logic while the NOR gate 318 outputs a 0 logic regardless of the state of the LReq signal. The next clock event will cause the transition to low of the Load signal of the current register without affecting the ff state that remains at a high state. This mean that the register is not clocked and that the data stalls in its position without being erased. As consequence, if the data in the second register stalls, the data in the current register stalls too. The current and next register hold valid data and their Load signal remains at a low state to prevent data shifting.

In the second case where the next register is not holding valid data (Nff=0) and LReq remains high, the NAND gate 306 and the NOR gate 318 outputs a 1 logic meaning that in the next clock event the ff and the load signal will remain high and consequently new data is loaded into the current register. At the same time Nff goes to high because the next register loaded the old data held by the current register.

The third case is when Nff is at a low state and LReq is at a low state. The NAND gate 306 and the NOR gate 318 outputs a 0 logic meaning that in the next clock event the ff and the load signals will go low and consequently the current register is not clocked and no longer holds valid data. At the same time, Nff goes to high because the next register is loaded with the old data held by the current register. In all these cases the CNT signal is considered to be at a high state. This is to make the controller operate in a normal mode as described above.

In normal mode, an issue may appear during the propagation of data. For example consider three empty registers controlled by three controllers. Suppose that in the first clock cycle the current register loads first data. If second data is available at the input of the first register, this data will be loaded in the second clock cycle and the first data will be simultaneously loaded into the second register. If third data is available at the input of the first register, this flit will not be loaded by this register in the next clock cycle. During this clock cycle the second data is loaded by the second register and the first data is loaded by the third register. Thus the second data is still held by the first register and it is so far considered as a valid data which may result in data duplication. The first data continues to propagate correctly through the queue but the second data continues to be duplicated. As a result in n clock cycles the first data reaches the register n and all the registers from 1 to n-1 are frozen and hold the second data. The CNT signal is used to address this by forcing the controller to operate in a shifting mode. When the CNT signal is low and after the clock event, the ff and Load output signals of the controller follow the Input LReq. Thus, a controller holding valid data and receiving a high LReq signal maintains its ff and Load output signals high to load the available data at the input of the register regardless of the full/empty state of the register that comes later. A controller holding valid data but receiving a low LReq signal forces both the ff and load signals to low to indicate that the register no longer holds valid data. This means each data is transferred from one register to another making all the stored data shift at the same time through the queue without being duplicated. Only controllers indicating valid data and/or receiving a high LReq signal may be sensitive to the CNT signal.

It should be appreciated that some embodiments may be implemented in an integrated circuit with an optical router. Other embodiments may be implemented in an integrated circuit with wired interconnects. Other embodiments may be implemented in wired/optical hybrid interconnect integrated circuits.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. A data serializer comprising:
an input configured to receive a plurality of sets of parallel data, each set of data comprising n bits;
at least one serializing stage configured to receive a set of n bits of parallel data and to convert said parallel data to a serial stream of data, said at least one serializing stage comprising a chain of flip flops each of which is arranged to selectively receive one of a bit of data and data output from a preceding flip flop, an output of a last flip flop of said chain of flip flops providing said serial stream of data.

2. A data serializer as claimed in claim 1, comprising an input flip flop, said input flip flop being arranged to selectively receive a first bit of said set of data and a low logic level, an output of said input flip flop being provided to an input of a first flip flop of said chain.

3. A data serializer as claimed in any preceding claim, comprising a plurality of serializing stages each configured to serialize a different set of data.

4. A data serializer as claimed in claim 3, wherein each serializing stage is clocked by a clock signal having the same clock frequency but a different phase such that data is clocked out of each of said serializing stages at different times.

5. A data serializer as claimed in claim 3 or 4, comprising a multiplexing arrangement configured to combine the output of each of the serializing stages into a single serial stream of data.

6. A data serializer as claimed in claim 5, wherein said multiplexing arrangement comprises a plurality of multiplexing layers.

7. A data serializer as claimed in any preceding claim, comprising a controller configured to provide a control signal for the serializing stage or respective control signals for each of said serializing stages to control the loading of a set of data into a respective serializing stage.

8. A data serializer as claimed in claim 7, wherein said controller is configured to provide the or each signal responsive to a data request signal being asserted.

9. A data serializer as claimed in claim 8, wherein said controller is configured to provide a reset signal for resetting at least one serializing stage.

10. A data serializer as claimed in any preceding claim, wherein said input comprises an interface having a plurality of data stores, each data store being sized so as to be able to store a set of data.

11. A data serializer as claimed in claim 10, wherein said interface is configured to cause a set of data to be shifted through said data stores.

12. A data serializer as claimed in claim 10 or 11, wherein at least one of said data stores is configured to output said data to the or one serializing stage only when said serializing stage is ready to serialize said data.

13. A data serializer as claimed in claim 10 , 11 or 12, wherein at least one of said data stores comprises a controller configured to stall said data store if said state of said data store is to be unchanged.

14. A data serializer as claimed in claim 13, wherein said controller is configured to stall said data store by gating a clock signal applied to said data store.

15. An integrated circuit comprising a data serializer as claimed in any preceding claim

16. A network on chip port comprising:
a data serializer configured to convert parallel data into serialized data and to transmit said serialize data; and
a data deserializer configured to receive serial data and convert said serial data into parallel data.
